(19) Europäisches Patentamt
European Patent Office
Office européen des brevets

(11) **EP 2 189 799 A1**

(12) **EUROPEAN PATENT APPLICATION**

(43) Date of publication:
**26.05.2010 Bulletin 2010/21**

(51) Int Cl.:
***G01R 27/20*** (2006.01)

(21) Application number: **08169622.1**

(22) Date of filing: **21.11.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **KOREA ELECTRIC POWER CORPORATION**
**Seoul 135-791 (KR)**

(72) Inventor: **Hwang, Soo Chun**
**Daejeon 305-810 (KR)**

(74) Representative: **Skone James, Robert Edmund et al**
**Gill Jennings & Every LLP**
**Broadgate House**
**7 Eldon Street**
**London EC2M 7LH (GB)**

(54) **Apparatus and method for three-pole type measuring of specific soil resistance for distribution grounding**

(57) Disclosed herein is an apparatus and method for measuring a specific soil resistance for distribution grounding by a three-electrode method. The apparatus uses three electrodes to measure a specific soil resistance as well as an earth resistance based on a three-electrode method in specific soil resistance measurement that is the most basic but likely to be overlooked in a practical distribution work.

FIG.7

**Description**

BACKGROUND OF THE INVENTION

1. Field of the Invention

The present invention relates to specific soil resistance measurement, and, more particularly, to an apparatus and method for measuring a specific soil resistance for distribution grounding, which uses three electrodes to measure the specific soil resistance as well as an earth resistance based on a three-electrode method in specific soil resistance measurement that is the most basic but likely to be overlooked in a practical distribution work.

2. Description of the Related Art

In general, as a method for measuring a specific soil resistance when constructing a design of a substation grounding, a tower grounding, or similar power transmission work, a four-electrode method proposed by Wenner in 1915 has been used.
However, since this method uses four or more electrodes (e.g., five electrodes), it is inconvenient to operate measurement instruments, and values obtained by repetitive measurements must be averaged. Further, since the specific soil resistance can vary depending on a gap between the electrodes, the four-electrode method does not ensure an advantageous measurement of the specific soil resistance. Also, the four-electrode method is inadequate for a design of distribution work using a ground rod as a unit. However, an apparatus for measuring a specific soil resistance for distribution according to this invention has an advantage in that it facilitates measurement of the specific soil resistance at a point where the ground rod is buried.
The four-electrode method used for the grounding work relating to power transmission systems measures the specific soil resistance of a large area, such as the substation grounding, the tower grounding, and the like, several times and obtains an average of the measured resistances. However, since the distribution work is sporadically and widely carried out in a very small region associated with installation of a ground rod, the four-electrode method is inconvenient and thus rarely utilized.

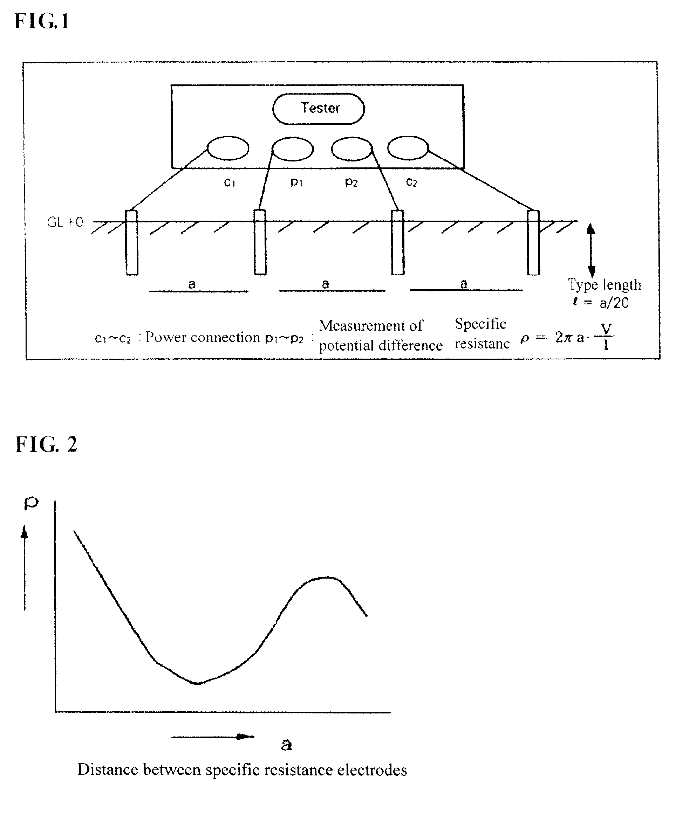

Fig. 1 is a view of a conventional four-electrode method for measuring the specific soil resistance.
Here, c1 ~ c2 are power connections; p1 ~ p2 are potential difference measurements; 1 is a length of a grounded electrode; a is a distance between the grounded electrodes; V is a voltage; and I is a current.
Wenner's four-electrode method is a method of arranging four electrodes at regular intervals in a straight line, which was published by Frank Wenner in 1915 and is the most frequently used method for measuring the specific soil resistance.
As shown in Fig. 1, four electrodes are installed in the earth, and a current I flowing in opposite outer-electrodes, and a voltage V induced between two inner-electrodes are measured to thereby calculate soil resistivity. Power is supplied between two outer grounded electrodes c1 and c2 to cause current to flow through the earth, and, at this time, a potential difference between the two inner grounded electrodes p1 and p2 is measured to obtain an earth resistance R ($\Omega$) from V/I. Further, if a distance between the electrodes is a [m], a soil resistivity p ($\Omega$.m) is calculated by Expression 1.

[Expression 1]

$$\rho = 2\pi a \cdot \frac{V}{I}$$

where the resistance R = V/I. If a burying depth of the grounded electrode for measurement is very small as compared to the distance between the electrodes, the soil resistivity is measured under a condition of a $\geq$ 20d since it is preferable to apply the four-electrode or four-point method to measurement. Expression 1 represents a mean soil resistivity of soil at an approximate depth of (0.75 ~ 1)a.
The soil resistivity is calculated regardless of the test voltage, current, and earth resistances at c1, c2, p1, and p2. If the distance "a" between the electrodes is large, the mean soil resistivity is measured at a depth as deep as the test current reaches. If a water pipe, a gas pipe or similar metal pipe is buried under the ground, the test current may be bypassed via such a conductive metal so that an error may occur. Therefore, to correctly measure the soil resistivity through the four-electrode method, it is desirable that the soil resistivity be measured many times and averaged while changing the arranging direction and the intervals of the four electrodes.

Fig. 2 is a graph depicting a general correlation between a specific resistance ($\rho$) and a distance (a) between the electrodes. As shown in Fig. 2, the specific soil resistance may vary depending on the intervals between the electrodes $c1 \sim c2$.

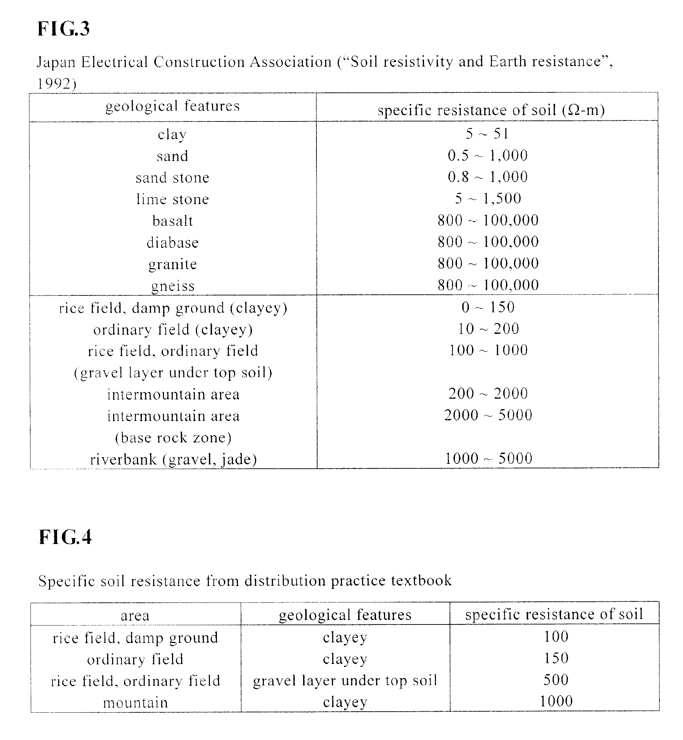

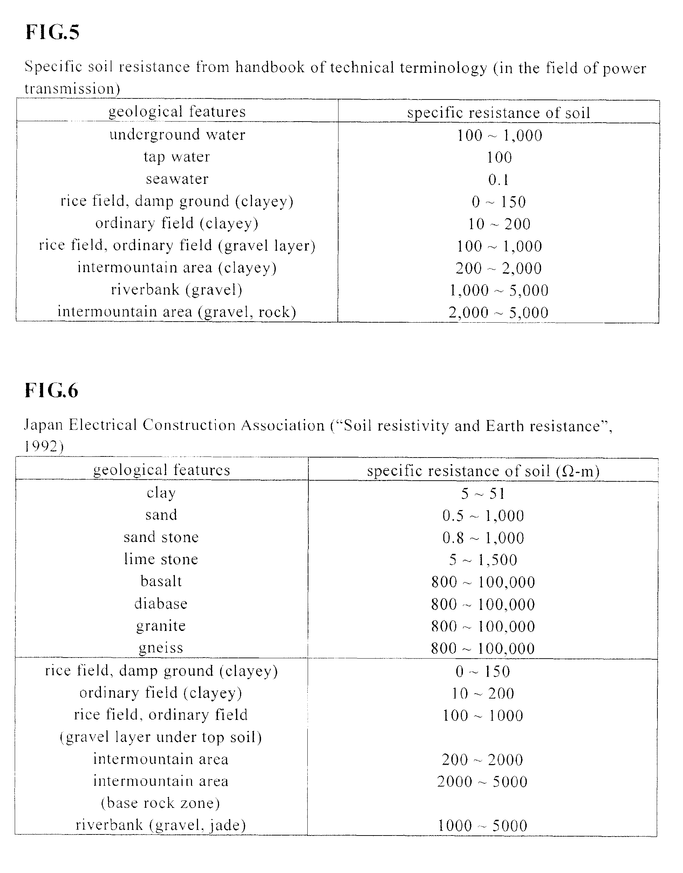

Fig. 3 is a table showing specific soil resistances according to General Design Standard 2601; Fig. 4 is a table showing specific soil resistances according to a general distribution practice textbook; Fig. 5 is a table showing specific soil resistances according to a handbook of technical terminology (in the field of power transmission); and Fig. 6 is a table showing specific soil resistances according to Japan Electrical Construction Association ("Soil resistivity and Earth resistance," July 1992).

Referring to Figs. 3 to 6, the specific soil resistances according to design standards are statistic values according to the kinds of soils, in which variation of the values is too large to be applied by a distribution designer.

There is no method other than the method of burying many electrodes under the ground and using a tester to measure the specific soil resistance.

However, since the conventional four-electrode method uses four or more electrodes, there are problems in that wiring is inconvenient and measurements are repeated many times. Further, although this method is adequate for a large area, the wiring work needs a smaller unit instrument for the grounding design and construction than that of the power transmission work, and is scattered at many points. Therefore, there is a need for a portable and convenient tester for measuring the specific soil resistance at a unit point where the ground rod is buried.

SUMMARY OF THE INVENTION

The present invention is conceived to solve the problems of the conventional techniques as described above, and an aspect of the present invention is to provide an apparatus for three-pole type specific soil resistance measurement for distribution grounding that uses three electrodes to measure a specific soil resistance as well as an earth resistance based on a three-electrode method in specific soil resistance measurement which is the most basic but likely to be overlooked in a practical distribution work.

In accordance with an aspect of the present invention, an apparatus for measuring a specific soil resistance for distribution through three electrodes includes: a power supply; a screw-type grounded electrode configured to receive power from the power supply and used in estimating the specific soil resistance by a three-electrode method; an earth resistance tester configured to measure an earth resistance of the screw-type grounded electrode; an A/D converter configured to convert an analog signal of an earth resistance measured by the earth resistance tester into a digital signal; a three-electrode method estimator configured to estimate the specific soil resistance using the three-electrode method based on the earth resistance converted by the A/D converter; and a display configured to display the specific soil resistance estimated by the three-electrode method estimator.

In accordance with another aspect of the present invention, a method of measuring a specific soil resistance for distribution through three electrodes includes: measuring an earth resistance value through a screw-type grounded electrode based on a three-electrode method; converting a signal of the measured analog earth resistance value into a signal of a digital earth resistance value; and estimating the specific soil resistance by the three-electrode method based on the converted signal of the digital earth resistance value.

BRIEF DESCRIPTION OF THE DRAWINGS

The above and other aspects, features and advantages of the present invention will become apparent from the following description of exemplary embodiments given in conjunction with the accompanying drawings, in which:

Fig. 1 is a view of a conventional four-electrode method for measuring a specific soil resistance;
Fig. 2 is a graph depicting a general correlation between a specific resistance ($\rho$) and a distance (a) between electrodes;
Fig. 3 is a table showing specific soil resistances according to General Design Standard 2601;
Fig. 4 is a table showing specific soil resistances according to a general distribution practice textbook;
Fig. 5 is a table showing specific soil resistances according to a handbook of technical terminology (in the field of power transmission);
Fig. 6 is a table showing specific soil resistances according to Japan Electrical Construction Association ("Soil Resistivity and Earth Resistance," July 1992);
Fig. 7 is a block diagram of an apparatus which measures a specific soil resistance for distribution through three electrodes according to an embodiment of the present invention;
Fig. 8 shows a screw type grounded electrode of Fig. 7;
Fig. 9 is a flowchart of a method for measuring the specific soil resistance for distribution through three electrodes according to an embodiment of the present invention;

Fig. 10 is a view of measuring the specific soil resistance according to an embodiment of the present invention;

Fig. 11 is a table showing inversely calculated specific soil resistances by a three-electrode method according to an embodiment of the present invention;

Fig. 12 is a comparative table showing actual measurements obtained using an inventive screw-type electrode, a conventional copper-type rod, and a conventional four-electrode method; and

Fig. 13 is a comparative table of the specific soil resistances in Fig. 12.

DETAILED DESCRIPTION OF THE INVENTION

Hereinafter, exemplary embodiments of the present invention will be described with reference to accompanying drawings.

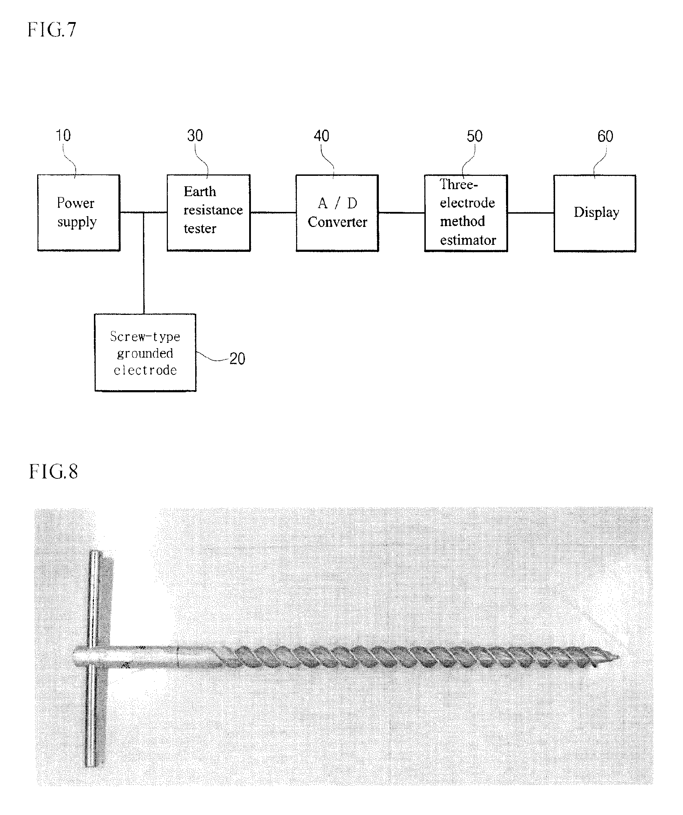

Fig. 7 is a block diagram of an apparatus for measuring a specific soil resistance for distribution through three electrodes according to an embodiment of the present invention, and Fig. 8 shows a screw type grounded electrode of Fig. 7.

As shown therein, an apparatus for measuring a specific soil resistance for distribution through three electrodes according to an embodiment of the present invention includes a power supply 10; a screw-type grounded electrode 20 which receives the power from the power supply 10 and is used in estimating the specific soil resistance by a three-electrode method; an earth resistance tester 30 which measures the earth resistance of the screw-type grounded electrode 20; an analog to digital (A/D) converter 40 which converts an analog earth resistance measured by the earth resistance tester 30 into a digital signal; a three-electrode method estimator 50 which uses the three-electrode method to estimate the specific soil resistance based on the earth resistance converted by the A/D converter 40; and a display 60 which displays the specific soil resistance estimated by the three-electrode method estimator 50.

In this embodiment, the screw-type grounded electrode 20 is made of carbon steel for machine structural use.

The three-electrode method estimator 50 estimates the specific soil resistance based on the following expression:

$$R = \frac{\rho}{2\pi L} \ln \frac{4L}{d}$$

where R is an earth resistance ($\Omega$), and $\rho$ is a specific soil resistance ($\Omega$ m), L is a length (m) of the screw-type grounded electrode 20, and d is a diameter (m) of the screw-type grounded electrode 20.

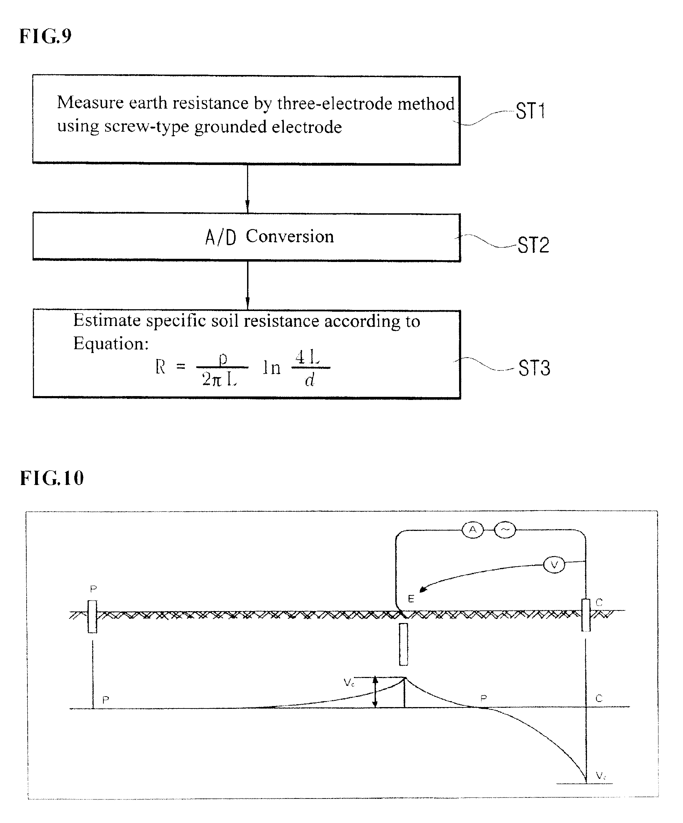

Fig. 9 is a flowchart of a method for measuring the specific soil resistance for distribution through three electrodes according to an embodiment of the present invention.

As shown therein, a method of measuring the specific soil resistance includes: measuring an earth resistance value through the screw-type grounded electrode 20 based on the three-electrode method in operation ST1; converting a signal of the analog earth resistance value measured in operation ST1 into a signal of a digital earth resistance value, in operation ST2; and estimating the specific soil resistance in operation ST3 by the three-electrode method based on the signal of the digital earth resistance value converted in operation ST2.

In this embodiment, the specific soil resistance is estimated in operation ST3 by the following expression:

$$R = \frac{\rho}{2\pi L} \ln \frac{4L}{d}$$

where R is an earth resistance ($\Omega$), and $\rho$ is a specific soil resistance ($\Omega$ m), L is a length (m) of the screw-type grounded electrode 20, and d is a diameter (m) of the screw-type grounded electrode 20.

With this configuration, the apparatus and the method for measuring the specific soil resistance through the three electrodes according to the present invention will be described as follows.

Herein, a detailed description of publicly known functions or configurations will be omitted for clarity so as not to unnecessarily obscure the subject matter of the invention. Further, the following terms are defined in consideration of functions of the present invention, which can be changed according to users, intention of an operator, a judicial precedent, etc., and should be understood based on the overall disclosure in this specification.

First, the apparatus according to the invention measures the specific soil resistance as well as the earth resistance by only the three-electrode method.

Fig. 10 is a view of measuring the specific soil resistance according to one embodiment of the present invention.

According to this embodiment, the screw-type grounded electrode 20 was manufactured in a screw shape to be easily embedded in the earth and used repeatedly, and made of SM45C as defined in KSD 3752 (carbon steel for machine structural use). Second, the specific soil resistances from respective grounded electrodes were compared with each other and analyzed by embedding a screw-type rod and a copper-type rod in the earth, followed by inversely estimating the specific soil resistance through a general earth-resistance measurement expression with an earth resistance measured by an earth tester. Third, a combined tester capable of measuring the specific soil resistance was developed by incorporating an inverse estimation function into an existing digital earth tester.

The standards of the screw-type grounded electrode 20 are as follows.

1) Straight length to a screw end point : 430mm
2) Screw creepage-length: 1,401 mm
3) Outer diameter of screw: 25mm
4) Inner diameter of screw: 12.5mm
5) Cross-sectional area of screw: $55,030mm^2$ (= $2\pi * R * h = 2\pi * R * 430$)
6) Converted diameter: 40.736mm (straight length and cross-sectional area are constant)(=$55,030/2\pi * R * 430$)

Further, inverse calculation of the specific soil resistance using the three-electrode method is based on Expression 2.

[Expression 2]

$$R = \frac{\rho}{2\pi L} \ln \frac{4L}{d}$$

where R is an earth resistance ($\Omega$ ), and p is a specific soil resistance ($\Omega$ m), L is a length (m) of the screw-type grounded electrode 20, and d is a diameter (m) of the screw-type grounded electrode 20.

Expression 2 can be changed into Expression 3 with respect to the specific soil resistance.

[Expression 3]

$$\rho = \frac{2\pi L R}{\ln \frac{4L}{d}}$$

For example, if the ground rod (11000*$\psi$ 14) is embedded within a construction site and 350$\Omega$ , 400$\Omega$ and 280$\Omega$ are measured, the specific soil resistance can be calculated by Equation 4.

[Expression 4]

$$\rho = \frac{2\times 3.14\times 1.0\times 350}{\ln \frac{4\times 1.0}{0.014}} = 388.6 (\Omega, m)$$

Expression 4 was expressed in the case of 350$\Omega$ .

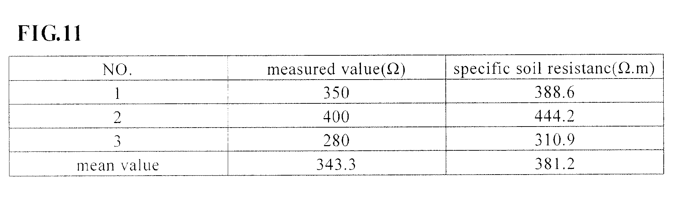

Fig. 11 is a table of inversely calculating the specific soil resistance using a three-electrode method according to an embodiment of the present invention. Fig. 11 shows the specific soil resistances which are inversely calculated in the case of 350$\Omega$, 400$\Omega$ and 280$\Omega$, respectively.

Meanwhile, the specific soil resistance estimated by the three-electrode method using the screw-type grounded electrode, the specific soil resistance obtained by the general earth-resistance measurement expression, and the specific soil resistance obtained by the conventional four-electrode method are compared and analyzed as follows.

First, in the case of using a general earth-resistance measurement expression,

The specific soil resistance is estimated by the three-electrode method using a general ground copper rod for distribution.

- The ground copper rod having a size of 14 $\phi$ and 1,000 mm was sunk to a depth of only 700mm, so that it can be installed and removed repeatedly for measurement. Here, 1 = 0.7 [m], d = 0.014 [m]
- Tester model: digital earth tester TK-2040
- Specific soil resistance: obtained by inversely estimating the earth resistance through the general earth resistance expression.

Second, in the case of using the conventional four-electrode method,

- Tester model: earth insulator tester (MI-2088) of METREL Horjul
- Specific soil resistance: obtained by direct measurement based on the four-electrode method (Wenner's four-electrode method)

Third, in the case of using the three-electrode method with the screw-type grounded electrode to estimate the specific soil resistance,

- The rod manufactured in a screw shape and having a size of 40.736$\phi$ and 430 mm (converted diameter and straight length) was used. Here, 1 = 0.43 [m], d = 0.040736 [m].
- Tester model: digital earth tester TK-2040
- Specific soil resistance: obtained by inversely estimating the earth resistance through the general earth resistance expression.

The specific soil resistance is obtained as in Expression 3.

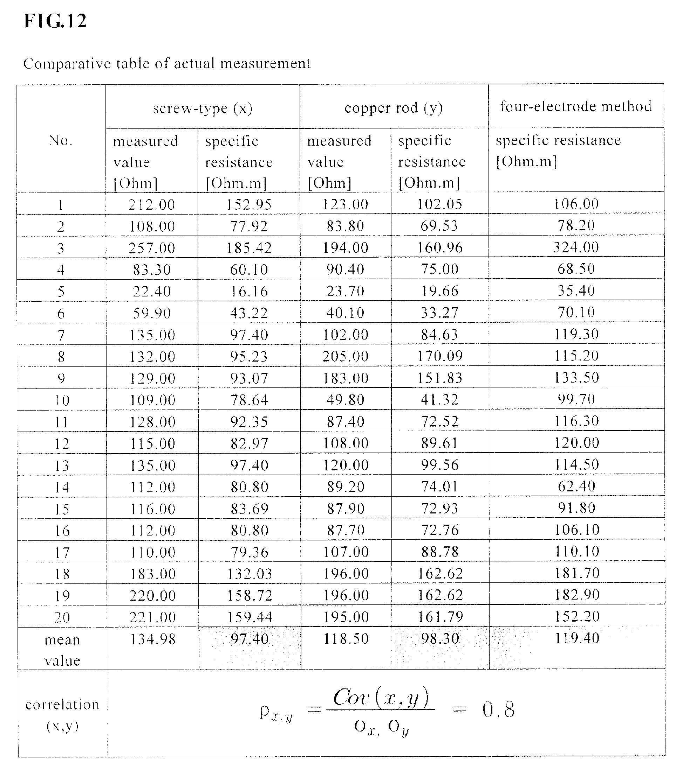

Fig. 12 is a comparative table showing actual measurements obtained using an inventive screw-type electrode, a conventional copper-type rod, and a conventional four-electrode method.

Results from comparing the specific soil resistance tester for distribution with the ground copper rod are shown in Fig. 12. However, the measurement based on the four-electrode method is provided merely for reference since this method is not applied to a small area where the ground rod is regarded as a unit.

Thus, based on results from analyzing the actual measurement, a measurement correlation between the inventive screw-type and the general copper rod is 0.8 as shown in Expression 5.

$$[\text{Expression 5}]$$

$$\rho_{x.y} = \frac{Cov(x,y)}{\sigma_x, \, \sigma_y} = 0.8$$

Further, as can be understood from the table shown in Fig. 12, the specific soil resistance with regard to a unit of a target ground rod approximately reaches a mean value of the screw-type or general copper-type measurement.

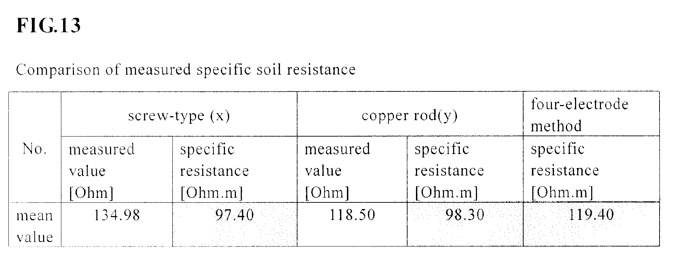

Fig. 13 is a comparative table of the specific soil resistances in Fig. 12.

As such, the present invention uses the three-electrode method to measure the specific soil resistance as well as the earth resistance in specific soil resistance measurement that is the most basic but likely to be overlooked in a practical distribution work.

As apparent from the foregoing description, the apparatus and method for three-pole type specific soil resistance measurement for distribution grounding according to the present invention uses three electrodes, thereby providing an effect of measuring the specific soil resistance as well as an earth resistance in the specific soil resistance measurement that is the most basic but likely to be overlooked in a practical distribution work.

In development of the apparatus (three electrodes) for measuring the specific soil resistance for distribution, the electrodes are manufactured in the form of a screw-type rod so as to be reused as a grounded electrode, and an inverse-estimation algorithm is embedded in a digital earth tester to be used as a tester for measuring both the earth resistance and the specific soil resistance.

According to the present invention, the apparatus has advantages in view of easy and efficient operability resulting from a combined function of measuring the earth resistance and the specific soil resistance and a portable structure, and can be directly used to enhance the quality of distribution design and/or construction.

Although the present invention has been described with reference to the embodiments and the accompanying drawings, it should be be apparent to those skilled in the art that the embodiments are given by way of illustration and that various modifications and equivalent embodiments can be made without departing from the spirit and scope of the present invention, as defined only by the accompanying claims.

**Claims**

1.  An apparatus for measuring a specific soil resistance for distribution through three electrodes, comprising:

    a power supply;
    a screw-type grounded electrode configured to receive power from the power supply and used in estimating the specific soil resistance by a three-electrode method;
    an earth resistance tester configured to measure an earth resistance of the screw-type grounded electrode;
    an A/D converter configured to convert an analog signal of an earth resistance measured by the earth resistance tester into a digital signal;
    a three-electrode method estimator configured to estimate the specific soil resistance using the three-electrode method based on the earth resistance converted by the A/D converter; and
    a display configured to display the specific soil resistance estimated by the three-electrode method estimator.

2.  The apparatus according to claim 1, wherein the screw-type grounded electrode comprises carbon steel for machine structural use.

3.  The apparatus according to claim 1 or 2, wherein the three-electrode method estimator estimates the specific soil resistance by the following expression:

$$R = \frac{\rho}{2\pi L} \ln \frac{4L}{d}$$

where R is an earth resistance ($\Omega$), and p is a specific soil resistance($\Omega$ m), L is a length (m) of the screw-type grounded electrode, and d is a diameter (m) of the screw-type grounded electrode.

4.  A method of measuring a specific soil resistance for distribution through three electrodes, the method comprising:

    measuring an earth resistance value through a screw-type grounded electrode based on a three-electrode method;
    converting a signal of the measured analog earth resistance value into a signal of a digital earth resistance value; and
    estimating the specific soil resistance by the three-electrode method based on the converted signal of the digital earth resistance value.

5.  The method according to claim 4, wherein the specific soil resistance is estimated by the following expression:

$$R = \frac{\rho}{2\pi L} \ln \frac{4L}{d}$$

where R is an earth resistance ($\Omega$), and p is a specific soil resistance ($\Omega$ m), L is a length (m) of the screw-type grounded electrode, and d is a diameter (m) of the screw-type grounded electrode.

## FIG.1

Tester

$c_1$   $p_1$   $p_2$   $c_2$

GL +0

a     a     a

Type length
$\ell = a/20$

$c_1\sim c_2$ : Power connection $p_1\sim p_2$ : Measurement of potential difference   Specific resistanc $\rho = 2\pi a \cdot \dfrac{V}{I}$

## FIG. 2

$\rho$

a

Distance between specific resistance electrodes

# FIG.3

Japan Electrical Construction Association ("Soil resistivity and Earth resistance", 1992)

| geological features | specific resistance of soil ($\Omega$-m) |
|---|---|
| clay | 5 ~ 51 |
| sand | 0.5 ~ 1,000 |
| sand stone | 0.8 ~ 1,000 |
| lime stone | 5 ~ 1,500 |
| basalt | 800 ~ 100,000 |
| diabase | 800 ~ 100,000 |
| granite | 800 ~ 100,000 |
| gneiss | 800 ~ 100,000 |
| rice field, damp ground (clayey) | 0 ~ 150 |
| ordinary field (clayey) | 10 ~ 200 |
| rice field, ordinary field (gravel layer under top soil) | 100 ~ 1000 |
| intermountain area | 200 ~ 2000 |
| intermountain area (base rock zone) | 2000 ~ 5000 |
| riverbank (gravel, jade) | 1000 ~ 5000 |

# FIG.4

Specific soil resistance from distribution practice textbook

| area | geological features | specific resistance of soil |
|---|---|---|
| rice field, damp ground | clayey | 100 |
| ordinary field | clayey | 150 |
| rice field, ordinary field | gravel layer under top soil | 500 |
| mountain | clayey | 1000 |

## FIG.5

Specific soil resistance from handbook of technical terminology (in the field of power transmission)

| geological features | specific resistance of soil |
|---|---|
| underground water | 100 ~ 1,000 |
| tap water | 100 |
| seawater | 0.1 |
| rice field, damp ground (clayey) | 0 ~ 150 |
| ordinary field (clayey) | 10 ~ 200 |
| rice field, ordinary field (gravel layer) | 100 ~ 1,000 |
| intermountain area (clayey) | 200 ~ 2,000 |
| riverbank (gravel) | 1,000 ~ 5,000 |
| intermountain area (gravel, rock) | 2,000 ~ 5,000 |

## FIG.6

Japan Electrical Construction Association ("Soil resistivity and Earth resistance", 1992)

| geological features | specific resistance of soil ($\Omega$-m) |
|---|---|
| clay | 5 ~ 51 |
| sand | 0.5 ~ 1,000 |
| sand stone | 0.8 ~ 1,000 |
| lime stone | 5 ~ 1,500 |
| basalt | 800 ~ 100,000 |
| diabase | 800 ~ 100,000 |
| granite | 800 ~ 100,000 |
| gneiss | 800 ~ 100,000 |
| rice field, damp ground (clayey) | 0 ~ 150 |
| ordinary field (clayey) | 10 ~ 200 |
| rice field, ordinary field (gravel layer under top soil) | 100 ~ 1000 |
| intermountain area | 200 ~ 2000 |
| intermountain area (base rock zone) | 2000 ~ 5000 |
| riverbank (gravel, jade) | 1000 ~ 5000 |

FIG.7

```
   10              30              40              50              60
┌──────────┐   ┌──────────┐   ┌──────────┐   ┌──────────┐   ┌──────────┐
│  Power   │   │  Earth   │   │  A / D   │   │  Three-  │   │          │
│  supply  │───│resistance│───│Converter │───│electrode │───│ Display  │
│          │   │  tester  │   │          │   │  method  │   │          │
└──────────┘   └──────────┘   └──────────┘   │estimator │   └──────────┘
      │                                       └──────────┘
      │
┌──────────┐
│Screw-type│
│ grounded │── 20
│electrode │
└──────────┘
```

FIG.8

**FIG.9**

Measure earth resistance by three-electrode method using screw-type grounded electrode — ST1

A/D Conversion — ST2

Estimate specific soil resistance according to Equation:

$$R = \frac{\rho}{2\pi L} \ln \frac{4L}{d}$$

— ST3

**FIG.10**

FIG.11

| NO. | measured value($\Omega$) | specific soil resistanc($\Omega$.m) |
|---|---|---|
| 1 | 350 | 388.6 |
| 2 | 400 | 444.2 |
| 3 | 280 | 310.9 |
| mean value | 343.3 | 381.2 |

## FIG.12

Comparative table of actual measurement

| No. | screw-type (x) | | copper rod (y) | | four-electrode method |
|---|---|---|---|---|---|
| | measured value [Ohm] | specific resistance [Ohm.m] | measured value [Ohm] | specific resistance [Ohm.m] | specific resistance [Ohm.m] |
| 1 | 212.00 | 152.95 | 123.00 | 102.05 | 106.00 |
| 2 | 108.00 | 77.92 | 83.80 | 69.53 | 78.20 |
| 3 | 257.00 | 185.42 | 194.00 | 160.96 | 324.00 |
| 4 | 83.30 | 60.10 | 90.40 | 75.00 | 68.50 |
| 5 | 22.40 | 16.16 | 23.70 | 19.66 | 35.40 |
| 6 | 59.90 | 43.22 | 40.10 | 33.27 | 70.10 |
| 7 | 135.00 | 97.40 | 102.00 | 84.63 | 119.30 |
| 8 | 132.00 | 95.23 | 205.00 | 170.09 | 115.20 |
| 9 | 129.00 | 93.07 | 183.00 | 151.83 | 133.50 |
| 10 | 109.00 | 78.64 | 49.80 | 41.32 | 99.70 |
| 11 | 128.00 | 92.35 | 87.40 | 72.52 | 116.30 |
| 12 | 115.00 | 82.97 | 108.00 | 89.61 | 120.00 |
| 13 | 135.00 | 97.40 | 120.00 | 99.56 | 114.50 |
| 14 | 112.00 | 80.80 | 89.20 | 74.01 | 62.40 |
| 15 | 116.00 | 83.69 | 87.90 | 72.93 | 91.80 |
| 16 | 112.00 | 80.80 | 87.70 | 72.76 | 106.10 |
| 17 | 110.00 | 79.36 | 107.00 | 88.78 | 110.10 |
| 18 | 183.00 | 132.03 | 196.00 | 162.62 | 181.70 |
| 19 | 220.00 | 158.72 | 196.00 | 162.62 | 182.90 |
| 20 | 221.00 | 159.44 | 195.00 | 161.79 | 152.20 |
| mean value | 134.98 | 97.40 | 118.50 | 98.30 | 119.40 |
| correlation (x,y) | $\rho_{x,y} = \dfrac{Cov(x,y)}{\sigma_x, \sigma_y} = 0.8$ | | | | |

## FIG.13

Comparison of measured specific soil resistance

| No. | screw-type (x) | | copper rod(y) | | four-electrode method |
|---|---|---|---|---|---|
| | measured value [Ohm] | specific resistance [Ohm.m] | measured value [Ohm] | specific resistance [Ohm.m] | specific resistance [Ohm.m] |
| mean value | 134.98 | 97.40 | 118.50 | 98.30 | 119.40 |

Europäisches
Patentamt

European
Patent Office

Office européen
des brevets

# EUROPEAN SEARCH REPORT

Application Number

EP 08 16 9622

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHEN Y ET AL: "Correlation between laboratory and field tests on the impulse impedance of rod-type ground electrodes" IEE PROCEEDINGS: GENERATION, TRANSMISSION AND DISTRIBUTION, INSTITUTION OF ELECTRICAL ENGINEERS, GB, vol. 150, no. 4, 14 July 2003 (2003-07-14), pages 420-426, XP006020476 ISSN: 1350-2360 * figure 2 * * table 3 * * page 421, left-hand column, paragraph 2 - right-hand column * * page 422, right-hand column, paragraph 4 * * page 426, right-hand column, paragraph 6 * ----- | 1-5 | INV. G01R27/20 |
| X | ZIPSE D W ED - ANONYMOUS: "Earthing - grounding methods: a primer" INDUSTRIAL AND COMMERICAL POWER SYSTEMS TECHNICAL CONFERENCE, 2002. 20 02 IEEE, IEEE, PI, 1 January 2002 (2002-01-01), pages 158-177, XP031098497 ISBN: 978-0-7803-7483-6 * figure 5 * * page 164, left-hand column, paragraph IV - page 165, left-hand column * ----- | 1,4 | TECHNICAL FIELDS SEARCHED (IPC) G01R |
| X | WO 93/19379 A (ELECTRONIC DEV INC [US]) 30 September 1993 (1993-09-30) * figure 1 * * page 1, line 6 - page 2, line 31 * * page 10, line 2 - line 14 * * page 11, line 36 - page 12, line 30 * * page 14, line 10 - line 26 * ----- -/-- | 1,2,4 | |

The present search report has been drawn up for all claims

| Place of search | Date of completion of the search | Examiner |
|---|---|---|
| Berlin | 21 April 2009 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 2 189 799 A1

Europäisches Patentamt
European Patent Office
Office européen des brevets

# EUROPEAN SEARCH REPORT

Application Number

EP 08 16 9622

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 11 002650 A (NIPPON TELEGRAPH & TELEPHONE) 6 January 1999 (1999-01-06)<br>* figures 1,2,8 *<br>* abstract *<br>* paragraph [0002] - paragraph [0004] *<br>* paragraph [0023] *<br>----- | 1,4 | |
| X | MICHAELS K M: "Earth ground resistance testing for low voltage power systems" INDUSTRIAL AND COMMERCIAL POWER SYSTEMS TECHNICAL CONFERENCE, 1994. CO NFERENCE RECORD, PAPERS PRESENTED AT THE 1994 ANNUAL MEETING, 1994 IEE E IRVINE, CA, USA 1-5 MAY 1994, NEW YORK, NY, USA,IEEE, 1 May 1994 (1994-05-01), pages 143-151, XP010121699 ISBN: 978-0-7803-1877-9<br>* figure 1 *<br>* page 143, right-hand column, paragraph II - page 144, right-hand column *<br>----- | 1,4 | |
| X | TAKAGI S ET AL: "A new method of measuring earth resistance by using the three-electrode method in which the grounding conductor is not disconnected from the earth electrode" TELECOMMUNICATIONS ENERGY CONFERENCE, 2000. INTELEC. TWENTY-SECOND INT ERNATIONAL SEPTEMBER 10-14, 2000, PISCATAWAY, NJ, USA,IEEE, 10 September 2000 (2000-09-10), pages 659-664, XP010523256 ISBN: 978-0-7803-6407-3<br>* figures 2,4,5 *<br>* page 660, left-hand column, paragraph 2 - page 661, left-hand column *<br>----- | 1,4 | |

TECHNICAL FIELDS SEARCHED (IPC)

-/--

The present search report has been drawn up for all claims

| Place of search | Date of completion of the search | Examiner |
|---|---|---|
| Berlin | 21 April 2009 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

17

Europäisches
Patentamt

European
Patent Office

Office européen
des brevets

## EUROPEAN SEARCH REPORT

Application Number

EP 08 16 9622

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 209 741 A (COBY AUGUST D [US] ET AL) 24 June 1980 (1980-06-24) <br> * figures 1,2 * <br> * column 1, line 33 - column 3, line 15 * <br> * column 4, line 57 - line 63 * <br> ----- | 1,4 | |
| X | EP 1 239 292 A (LEM NORMA GMBH [AT]) 11 September 2002 (2002-09-11) <br> * figures 1a,2,3 * <br> * paragraph [0001] - paragraph [0002] * <br> * paragraphs [0017], [0019] * <br> ----- | 1,4 | |
| X | WO 2006/115380 A (KOREA ELECTRONICS TELECOMM [KR]; LEE SANG-MU [KR]) 2 November 2006 (2006-11-02) <br> * figures 1,3 * <br> * paragraphs [0002], [0007], [0016] * <br> * paragraph [0020] - paragraph [0022] * <br> * paragraph [0031] - paragraph [0033] * <br> ----- | 1,4 | |
| A | CLARK R J ET AL: "Some Chemical Treatments to Reduce the Resistance of Ground Connections" IEEE TRANSACTIONS ON POWER APPARATUS AND SYSTEMS, IEEE INC. NEW YORK, US, vol. 71, no. 3, 1 April 1960 (1960-04-01), pages 1016-1023, XP011210758 ISSN: 0018-9510 * page 1016, middle column - right-hand column * <br> ----- <br> -/-- | 1-5 | TECHNICAL FIELDS SEARCHED (IPC) |

The present search report has been drawn up for all claims

| Place of search | Date of completion of the search | Examiner |
|---|---|---|
| Berlin | 21 April 2009 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                              

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 08 16 9622

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | RUAN W ET AL: "Perfonnance of HVDC ground electrode in various soil structures" POWER SYSTEM TECHNOLOGY, 2002. PROCEEDINGS. POWERCON 2002. INTERNATION AL CONFERENCE ON, PISCATAWAY, NJ, USA,IEEE, vol. 2, 13 October 2002 (2002-10-13), pages 962-968, XP010614898 ISBN: 978-0-7803-7459-1 * page 963, left-hand column, paragraph A * | 1-5 | |
| A | FR 2 668 138 A (ELECTRICITE DE FRANCE [FR]) 24 April 1992 (1992-04-24) * figures 1,2 * * abstract * * page 10, line 13 - line 20 * | 1,4 | |

**TECHNICAL FIELDS SEARCHED (IPC)**

The present search report has been drawn up for all claims

| Place of search | Date of completion of the search | Examiner |
|---|---|---|
| Berlin | 21 April 2009 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 08 16 9622

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2009

| Patent document cited in search report | | Publication date | Patent family member(s) | | Publication date |
|---|---|---|---|---|---|
| WO 9319379 | A | 30-09-1993 | US | 5365179 A | 15-11-1994 |
| JP 11002650 | A | 06-01-1999 | JP | 3167016 B2 | 14-05-2001 |
| US 4209741 | A | 24-06-1980 | NONE | | |
| EP 1239292 | A | 11-09-2002 | AT | 5503 U1 | 25-07-2002 |
| | | | US | 2002148624 A1 | 17-10-2002 |
| WO 2006115380 | A | 02-11-2006 | EP | 1875253 A1 | 09-01-2008 |
| | | | JP | 2008539418 T | 13-11-2008 |
| | | | US | 2008265897 A1 | 30-10-2008 |
| FR 2668138 | A | 24-04-1992 | NONE | | |

EPO FORM P0459

For more details about this annex : see Official Journal of the European Patent Office, No. 12/82